# EUROPÄISCHE PATENTANMELDUNG

(11) **EP 0 790 082 A2**
(43) Veröffentlichungstag der Anmeldung: **20.08.1997**
(21) Anmeldenummer: 97101701.7
(22) Anmeldetag: 04.02.1997
(51) Int. Cl.: B05C 11/08, B05C 11/10

(54) **Vorrichtung zur Oberflächenbeschichtung bzw. zum Lackieren von Substraten**

(30) Priorität: 15.02.1996 DE 19605601
(71) Anmelder: Singulus Technologies GmbH, 63755 Alzenau (DE)
(72) Erfinder: Sichmann, Eggo, 63571 Gelnhausen (DE); Gerigk, Reinhard, 63571 Gelnhausen (DE)
(74) Vertreter: Heunemann, Dieter, Dr.

(57) **Zusammenfassung**

**Die Erfindung bezieht sich auf** eine Vorrichtung zur Oberflächenbeschichtung bzw. zum Lackieren von Substraten bzw. scheibenförmigen Substraten 2 wie scheibenförmigem Informationsträger, der auf einen Substratträger 14 aufbringbar und über eine Antriebsvorrichtung 3 antreibbar bzw. in eine Rotationsbewegung versetzbar ist, wobei das aufzutragende Mittel bzw. die Lackflüssigkeit 5 über eine gegenüber dem Substrat 2 verstellbare und/oder antreibbare Zuführeinrichtung 6 auf das Substrat 2 aufgegeben wird. Das Substrat 2 bzw. der Substratträger 14 ist mittels einer Führungseinrichtung bzw. in einer Kulissenführung 7 derart verstellbar, daß die Zuführeinrichtung 6 zur Aufbringung der Flüssigkeit bzw. des Lacks im Bereich des Substrats 2 in etwa parallel zur Oberfläche des Substrats 2 geführt und an jeder beliebigen Stelle oberhalb des Substrats 2 im gleichmäßigen Höhenabstand angehalten werden kann.

## Beschreibung

**Die Erfindung bezieht sich auf** eine Vorrichtung zur Oberflächenbeschichtung bzw. zum Lackieren von Substraten bzw. scheibenförmigen Substraten wie einem scheibenförmigen Informationsträger, der auf einen Substratträger aufbringbar und über eine Antriebsvorrichtung antreibbar bzw. in eine Rotationsbewegung versetzbar ist, wobei das aufzutragende Mittel bzw. die Lackflüssigkeit über eine gegenüber dem Substrat verstellbare und/oder antreibbare Zuführeinrichtung auf das Substrat aufgegeben wird.

**Es ist bereits eine Zuführeinrichtung** zum Aufbringen von Lack auf Oberflächen von Substraten allgemein bekannt, die in einer Tragvorrichtung geführt wird, so daß die Lackflüssigkeit mittels einer Düse auf der Oberfläche des Substrats abgegeben werden kann. Mit einer derartigen Anordnung ist kein einwandfreier Lackauftrag gewährleistet, da in verschiedenen Stellungen der Zuführeinrichtung sich der Abstand zwischen der Düse und der Oberseite des Substrats verändert. Dadurch kann die Dicke des Lackauftrags ebenfalls nachteilig beeinflußt werden.

**Demgemäß besteht die Erfindungsaufgabe darin**, eine verbesserte Vorrichtung zum Lackieren von Substraten zu schaffen, mit der ein gleichmäßiger Lackauftrag auf der gesamten Oberfläche des Substrats gewährleistet wird.

**Gelöst wird die Aufgabe erfindungsgemäß dadurch, daß** das Substrat bzw. der Substratträger eine Führungseinrichtung bzw. eine Kulissenführung aufweist, die einen ersten und zweiten Führungsteil enthält, die mit Bezug auf die Standfläche der Vorrichtung einen unterschiedlichen Abstand aufweisen. Durch den Einsatz einer Kulissenführung läßt sich die Zuführeinrichtung mit der zugehörigen Düse exakt und parallel zur Oberfläche des Substrats entlangführen, so daß an jeder beliebigen Stelle des Substrats ein konstanter Abstand zwischen der Ausgangsöffnung der Düse und der Oberfläche des Substrats entsteht. Hierdurch wird auch ein gleichmäßiger Lackauftrag gewährleistet.

Hierzu ist es vorteilhaft, daß die Zuführungseinrichtung mit der Antriebsvorrichtung verbunden und von einer Tragvorrichtung aufgenommen ist und daß die Zuführeinrichtung mittels der Führungseinrichtung in horizontaler und/oder in vertikaler Richtung verstellbar ist.

Eine zusätzliche Möglichkeit ist gemäß einer Weiterbildung der erfindungsgemäßen Vorrichtung, daß die Antriebsvorrichtung mit einem Schrittmotor bzw. elektrischen oder elektrohydraulischen Schrittmotor wirkungsmäßig verbunden ist und daß die Antriebsvorrichtung einen Schrittmotor aufweist, der über ein Getriebe bzw. Zahnstangen- oder Schneckengetriebe mit der Führungseinrichtung wirkungsmäßig verbunden ist. Durch den Einsatz eines Schrittmotors läßt sich eine digitale Ansteuerung des Schrittmotors vornehmen und somit eine exakte Positionierung der Düse oberhalb des Substrats, so daß jede beliebige Fläche, also eine kleine oder eine große Beschichtungsfläche, mit Lack versehen werden kann und daß auch über die gesamte Oberfläche eine gleichmäßige Lackdicke erreicht wird, da die Düse lediglich parallel zur Oberfläche des Substrats geführt und genau an der gewünschten, eingestellten Stelle angehalten wird.

In weiterer Ausgestaltung der Erfindung ist es vorteilhaft, daß die Antriebsvorrichtung in einem Tragarm angeordnet oder diesem zugeordnet ist, in der die Kulissenführung vorgesehen ist, die aus einem ersten horizontal, einem sich daran anschließenden, geneigt verlaufenden und sich wiederum daran anschließenden, horizontal verlaufenden Teil gebildet ist, in der Gleitelemente bzw. Rollager vorgesehen sind bzw. sich bewegen, wobei neben der ersten Kulissenführung eine zweite Kulissenführung vorgesehen sein kann, die parallel zum ersten und/oder zweiten Teil verläuft, und daß in der Zuführeinrichtung zur Förderung der Flüssigkeit bzw. des Lacks eine Versorgungsleitung aufgenommen ist, die gemeinsam mit der Zuführeinrichtung verstellbar ist.

Gemäß einer bevorzugten Ausführungsform der erfindungsgemäßen Lösung ist schließlich vorgesehen, daß der Schrittmotor mit einem Sensor in einer Endlagestellung zusammenwirkt, von der aus die Stellung der Zuführeinrichtung und der Schrittmotor vorwählbar und in jede beliebige Stellung oberhalb des Substrats verstellbar ist, und daß das über die Zuführeinrichtung mit Lack versorgbare Substrat auf einem Substrathalter auflegbar ist, der mit einer den Substrathalter umgebenden, kreisförmigen bzw. zylinderförmigen Leitvorrichtung ausgestattet ist.

Ferner ist es vorteilhaft, daß die Leitvorrichtung aus zwei pyramidenstumpfförmigen, gegeneinander anliegenden Leitflächen bzw. Leitelementen besteht, über die der Lack einem ersten Behälter zugeführt wird, und daß die erste Leitvorrichtung von einer zweiten kreisförmigen bzw. zylinderförmigen Leitvorrichtung umgeben ist.

In weiterer Ausgestaltung der Erfindung ist es vorteilhaft, daß die erste und zweite kreis- bzw. zylinderförmige Leitvorrichtung mindestens je eine Öffnung aufweist, wobei die erste Öffnung eine Ablauföffnung für Lack und die zweite eine Absaugöffnung für den Lacknebel ist und daß ein koaxial angeordneter Teil der zweiten Leitvorrichtung mit einer zentrisch angeordneten Bohrung ausgestattet ist.

Außerdem ist es vorteilhaft, daß der Substratträger von beiden Leitvorrichtungen koaxial umgeben ist und daß der Substratträger von mindestens einer Leitvorrichtung bzw. von der inneren Leitvorrichtung getragen wird.

Durch die erfindungsgemäße Vorrichtung wird also das bisherige manuelle Nachjustieren ausgeschaltet, so daß auch bei laufender Anlage der Schrittmotor die Düse an jede beliebige Stelle bringen kann, an der der Lackauftrag beginnen soll. Die gesamte Anlage muß für den Einstellvorgang der Düse nicht abgeschaltet und der Rezipientendeckel nicht angehoben werden, um eine Handjustierung vorzunehmen. Mit der erfindungsgemäßen Programmsteuerung lassen sich in eine Steuereinrichtung unterschiedliche Lackdurchmesser eingeben, die dann den Schrittmotor anhalten, wenn die Lackdüse die gewählte Position erreicht hat. Zum manuellen Nachjustieren des Stellweges der Düse ist keine Unterbrechung der Produktion erforderlich.

**Weitere Vorteile und Einzelheiten der Erfindung sind in den Patentansprüchen** und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Figur 1: eine schematische Darstellung der gesamten Vorrichtung zum Lackieren von Substraten bzw. Compact Disks (CD),
- Figur 2: einen Lackierkopf mit einer zugehörigen Leitvorrichtung zum Auffangen des abgeschleuderten Lacks und zum Absaugen des Lacknebels,
- Figur 3: eine Zuführeinrichtung mit einer Düse, die über eine Kulissenführung in horizontaler und vertikaler Richtung verstellt werden kann,
- Figur 4: eine Schnittdarstellung entlang der Linie A-A gemäß Figur 3.

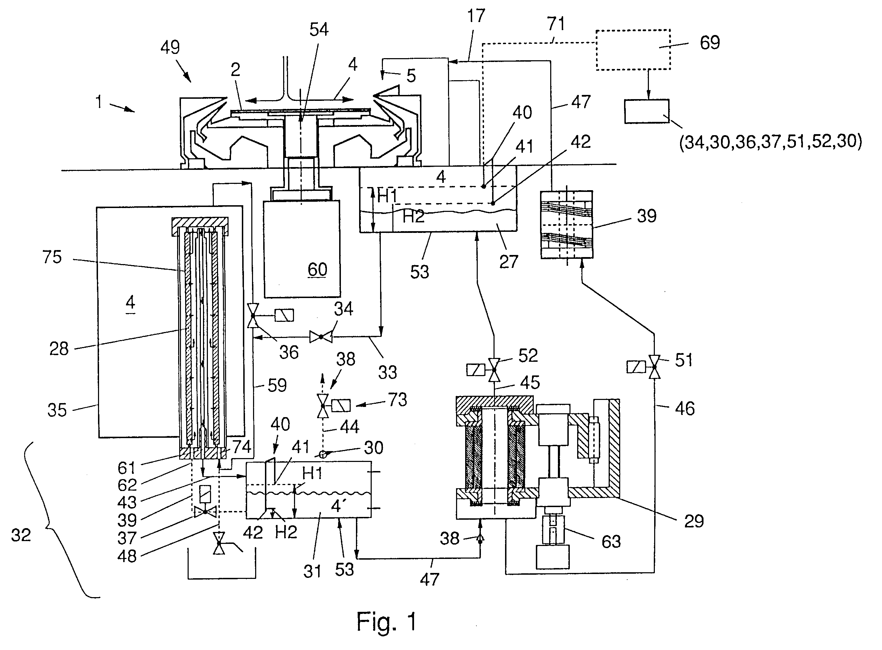

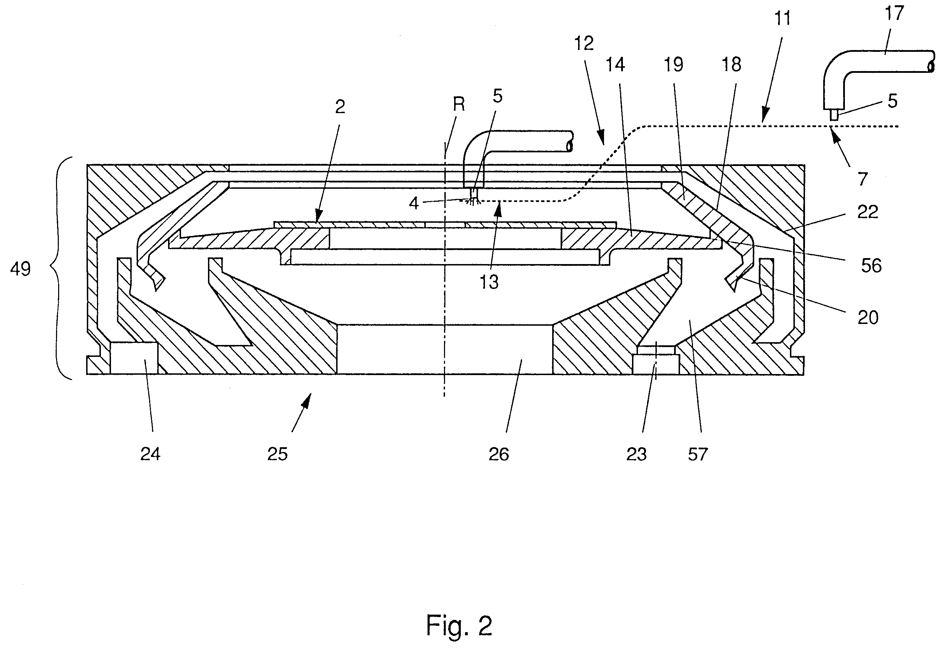

In der Zeichnung ist in Figur 1 die gesamte Vorrichtung zur Oberflächenbeschichtung bzw. zum Lackieren von Substraten 2 mit 1 bezeichnet, zu der ein Lackierkopf 49 gehört, der in Figur 2 näher veranschaulicht ist.

Der Lackierkopf 49 ist gemäß Figur 1 und 2 über eine Welle 54 mit einem Antriebsmotor 60 antriebsverbunden.

Der Lackierkopf 49 weist eine Leitvorrichtung 18 auf, die aus zwei pyramidenstumpfförmigen, gegeneinander anliegenden, fest miteinander verbundenen Leitelementen 19, 20 besteht, die über Öffnungen aufweisende Stege 56 mit einem Substratträger bzw. Teller 14 fest verbunden sind. Der obere Teil des Leitelements 19 der Leitvorrichtung 18 verläuft mit Bezug auf die Mittelachse R geneigt und nach oben pyramidenförmig zu. An die Leitvorrichtung 19 schließt sich, wie bereits erwähnt, das untere, sich ebenfalls zur Mittelachse R verjüngende Leitelement 20 an. Die Leitvorrichtung 18 mündet in einen Ringkanal 57, der über eine Leitung gemäß Figur 1 in einen ersten Auffangbehälter 27 mündet.

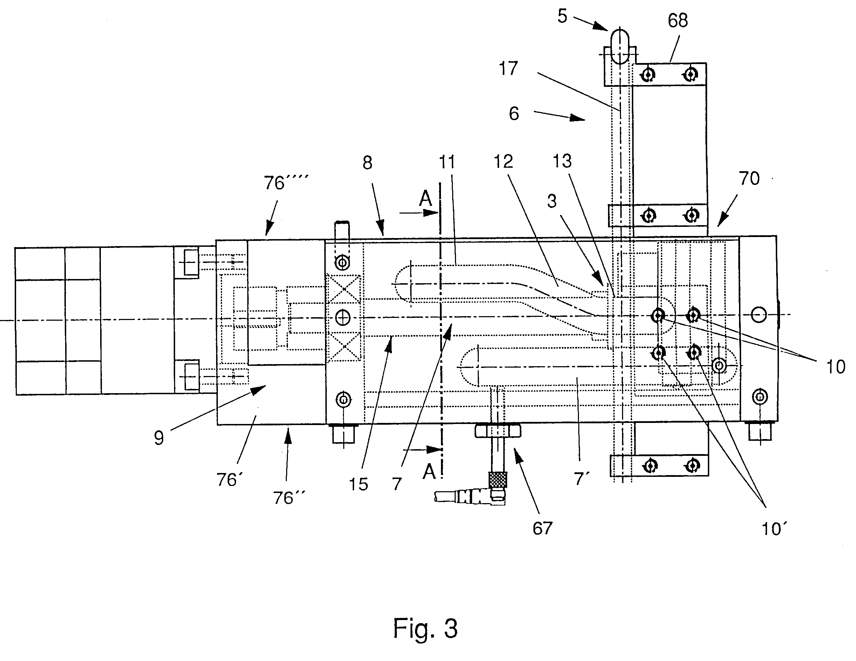

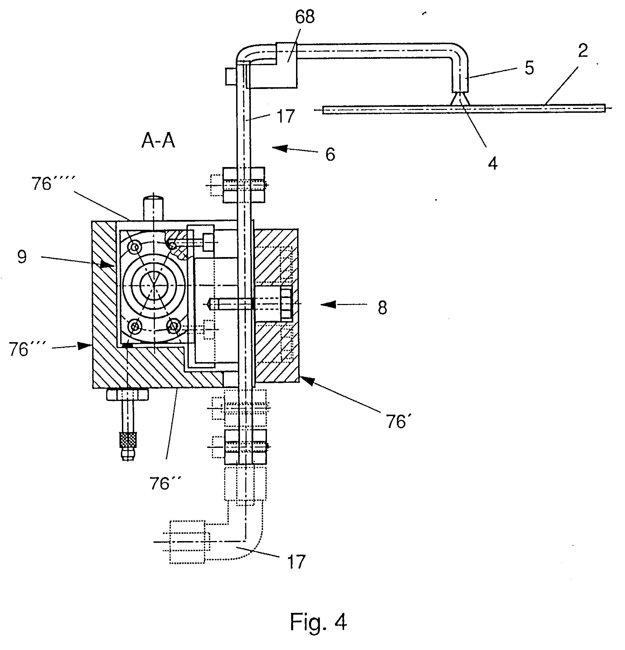

Eine Flüssigkeit bzw. ein Lack 4 (Figur 3) gelangt über eine Zuführeinrichtung 6, wie aus der nachstehend näher beschriebenen Vorrichtung gemäß Figur 3 und 4 hervorgeht, und eine zugehörige Düse 5 auf das Substrat 2, während das Substrat 2 über den Motor 60 in Rotation versetzt wird. Bei diesem Vorgang fließt der Lack 4 infolge der Zentrifugalkraft auf der Oberfläche des Substrats 2 radial nach außen und gelangt über den Rand des Substrats und die Leitvorrichtung 18 in den Ringkanal 57. Weitere überschüssige Lackpartikel werden in Form eines Lacknebels von der Oberfläche des Substrats 2 abgeschleudert. Diese Lackteile werden von einer zweiten ringförmig ausgebildeten, sich an die Außenkontur des Leitelements 19 anschließenden Leitvorrichtung 22 abgesaugt, die im unteren Bereich eine Absaugöffnung 24 aufweist, so daß die über die Leitvorrichtung 22 aufgefangenen Lackteilchen ebenfalls dem ersten Sammelbehälter 27 zugeführt werden können. Die abgeschleuderte Lackflüssigkeit gelangt über den Lackierkopf 49 bzw. die zugehörigen Leitelemente 19, 20 und die zugehörige Auslaßöffnungen 23 in den ersten Sammelbehälter 27. Der erste Sammelbehälter 27 ist über eine Flüssigkeitsleitung 33, die als Rücklaufleitung ausgebildet ist, und über ein erstes Steuerventil 34 an eine Flüssigkeitsleitung 59 angeschlossen, die mit dem oberen Ende eines dritten Sammelbehälters 35 und mit ihrem unteren Ende an eine Einlaßöffnung 74 eines Filters 28 angeschlossen ist.

In der Leitung 59 befindet sich ein zweites Ventil 36, über das der Tank 35 über die Leitung 59 mit der Einlaßöffnung 74 des Filters 28 verbunden werden kann, wenn Lackflüssigkeit 4 aus dem Tank 35 über den Filter 28 einem zweiten Auffangbehälter 31 zugeführt werden soll. Hierzu ist die Auslaßöffnung 61 des Filters 28 über eine Leitung 43 an das obere Ende des zweiten Sammelbehälters 31 angeschlossen. Das untere Ende des Sammelbehälters 31 steht ferner über ein Ventil 37 und eine Leitung 39 mit einer zweiten Einlaßöffnung 62 des Filters 28 in Verbindung, so daß die im Filter verbleibende, gefilterte Flüssigkeit in den zweiten Sammelbehälter 31 ablaufen kann, wenn die Filterpatrone des Filters 28 gewechselt werden soll. Der Filter 28 ist mit einem zentrisch angeordneten Rohr 75 ausgestattet, das gewährleisten soll, daß Flüssigkeit über das obere Ende des Rohrs fließt und somit die Filterpatrone immer vollständig in Flüssigkeit liegt.

Von dem ersten Sammelbehälter 31 gelangt die Lackflüssigkeit 4' über eine Leitung 47 zu einer Pumpe, die als Dosierpumpe 29 ausgebildet sein kann. Die Pumpe 29 wird über einen Schrittmotor 63 angetrieben, so daß bei einem entsprechenden Steuerimpuls Lackflüssigkeit aus dem Sammelbehälter 31 über die Dosierpumpe 29 sowie eine Leitung 46, ein Steuerventil 51, eine elektrische Heizung 39 und die Leitung 47 dem Lackierkopf 49 zugeführt werden kann.

Die Pumpe bzw. die Dosierpumpe 29 steht außerdem über eine Leitung 45 und ein Steuerventil 52 mit dem ersten Auffangbehälter 27 in Verbindung. Damit die Pumpe bzw. Membranpumpe 29 einwandfrei arbeiten kann, ist unter der Dosierpumpe 29 ein Rückschlagventil 38 vorgesehen. Das Rückschlagventil 38 stellt sicher, daß lediglich die Lackflüssigkeit 4' aus dem zweiten Auffangbehälter 31 zum ersten Auffangbehälter 27 gefördert wird.

Damit eine einwandfreie Versorgung der beiden Lackbehälter bzw. Auffangbehälter 27 und 31 mit Lackflüssigkeit sichergestellt wird, weist die gesamte Vorrichtung 1 eine bzw. zwei Füllstandsanzeigevorrichtungen 40 auf, die über eine elektrische Leitung 71 mit einer Auswerteinheit bzw. Steuer- oder Regeleinrichtung 69 verbunden ist, über die die einzelnen Ventile bzw. elektrisch oder pneumatisch betreibbaren Ventile 34, 36, 37, 51, 52 sowie 30 angesteuert werden können, um die Lackflüssigkeit in die gewünschte Richtung bzw. zu den einzelnen Sammelbehältern 27, 31 und dem Substrat 2 zu leiten.

Die Füllstandsanzeige 40 besteht gemäß Figur 1 unter anderem aus zwei mit Abstand zueinander angeordneten Meßfühlern 41, 42, die in dem oberen Auffangbehälter 27 und in dem unteren Auffangbehälter 31, der auch als zweiter Behälter 27 bezeichnet wird, untergebracht sind. Der erste Meßfühler 41 weist eine Höhe H₁ und der zweite Meßfühler 42 eine Höhe H₂ mit Bezug auf einen Boden 53 auf.

Im Sammelbehälter 31 sind ebenfalls zwei gleiche Meßfühler 41, 42 angeordnet, die mit Bezug auf den Boden 53 einen oberen Meßpunkt mit der Höhe H₁ und eine Höhe H₂ aufweisen. Diese beiden Meßpunkte der beiden Meßfühler 41, 42 können vom Lack benetzt werden. Die Fühler 41, 42 werden mit einer Gleichspannung versorgt, wobei der Widerstandswert zum Gehäuse gemessen wird. Die unterschiedliche Füllhöhe im Sammelbehälter 27 oder 31 beeinflußt den Widerstandswert. Die Signalauswertung der Meßwerte der beiden Meßfühler 41, 42 kann jederzeit dann neu kalibriert werden, wenn die im Auffangbehälter 27, 31 eingebrachte Flüssigkeit die beiden Meßpunkte benetzt.

Die Meßfühler 41, 42 und der Auffangbehälter 27, 31 sind über je eine elektrische Leitung 71 an die Auswerteinheit 69 angeschlossen, die die Meßwerte mittels der Fühler 41 und 42 erfaßt und die so ermittelten Meßwerte aus den unterschiedlichen Höhen als Steuergröße zur Ansteuerung der einzelnen Ventile einsetzt, um beispielsweise die beiden Auffangbehälter 27 und 31 mit Flüssigkeitsmedium zu versorgen und bei einem bestimmten Verschmutzungsgrad das Schaltventil 34 zum Filter 28 zu schließen.

Beim Einfüllvorgang der Flüssigkeit bzw. des Lacks 4 in einen Sammelbehälter kann auf empirische Weise eine sogenannte Hintergrundkurve bzw. Meßkurve (Widerstand über der Einfüllhöhe) ermittelt werden, so daß diese Kurve später bei der Höhenmessung der Flüssigkeit im Sammelbehälter als relative Referenzgröße zur Verfügung steht. Da nach längerem Einsatz der umlaufenden Lackflüssigkeit sich der Feuchtigkeitsgehalt im Lack verändern kann, ist es wichtig, daß eine fortlaufende Kalibrierung der Widerstandselemente bzw. Meßfühler vorgenommen wird. Nach einer derartigen Kalibrierung kann auch mit lediglich einem Meßfühler, beispielsweise mit dem Meßfühler 42, jeweils die Ist-Größe bzw. die Füllhöhe im Sammelbehälter 27 und/oder 31 ermittelt werden. Die so ermittelten Meßpunkte oder Widerstandsmeßwerte über den jeweiligen Befüllungszustand geben der Bedienungsperson Auskunft darüber, wann beispielsweise der untere Sammelbehälter 31 wieder über den Tank 35 mit neuem Lack oder über den Auffangbehälter 27 mit gebrauchtem Lack versorgt werden soll. Dadurch besteht die Möglichkeit, daß die Bedienungsperson beispielsweise einen freiwählbaren maximalen Füllstand im Lacktank einstellen kann, bevor Lack aus dem oberen Behälter 27 oder aus dem Tank 35 nachgefüllt wird. Hierzu wird über die Steuereinheit 69 das Ventil 36 des Tanks 35 geöffnet, und die Lackflüssigkeit kann dann über die Leitung 59 und die Einlaßöffnung 74 zum Filter 28 geleitet werden, von dem dann die gereinigte Lackflüssigkeit über die Auslaßöffnung 61 und die Leitung 43 in den oberen Bereich des Sammelbehälters 31 eingefüllt wird. Auf diese Weise wird dem zweiten Sammelbehälter 31 jeweils gereinigte Lackflüssigkeit zugeführt.

Der Zeitpunkt des Filteraustauschs läßt sich ebenfalls mittels der Meßfühler 41, 42 ermitteln. Da bei Kenntnis über den Füllstand beider Auffangbehälter 27 und 31 die zu ermittelnde Rücklaufgeschwindigkeit der gereinigten Flüssigkeit aus dem Filter 28 bestimmt werden kann, kann auch die Rücklaufmenge eine Größe zur Ansteuerung der Ventile 34, 36 sein, das dann geschlossen werden muß, wenn der Filter 28 bei erheblicher Verschmutzung ausgetauscht werden muß. Durch die reduzierte Rücklaufmenge aus dem Filter 28 wird auch der Auffangbehälter 31 nicht mehr so schnell nachgefüllt, so daß dieser Zeitfaktor in Verbindung mit der Füllhöhe im Sammelbehälter 31 eine Stellgröße darstellt, anhand derer, wie bereits erwähnt, der beschriebene Filteraustausch sinnvoll ist.

Auch der obere Auffangbehälter 27 soll in vorteilhafter Weise lediglich eine minimale Menge an Lackflüssigkeit aufweisen, damit in der Gesamtanlage nur wenig Lackflüssigkeit fortlaufend umgewälzt wird. Hierdurch wird sichergestellt, daß in der Lackflüssigkeit kein Alterungsprozeß eintritt, da nach relativ kurzer Zeit der Lack größtenteils aufgebraucht wird bevor ungebrauchter Lack aus dem Tank 35 dem Sammelbehälter 31 zugeleitet wird. Hierzu wird das Steuerventil 36 über die Auswert- bzw. Steuereinheit 69 geöffnet und der Lack fließt über den Filter 28 in den Sammelbehälter 31, bis die gewünschte maximale Füllhöhe erreicht und der Meßfühler 41 für die automatische Kalibrierung mit Flüssigkeit in Berührung gebracht wird. Nach diesem Zeitpunkt wird das Steuerventil 34 oder 36 wieder automatisch in eine Schließstellung gebracht.

Durch die vorteilhafte Anordnung der beiden jeweils in einem Sammelbehälter angeordneten Meßfühler 41, 42 lassen sich fortlaufend Meßwerte bzw. Widerstandsmeßwerte ermitteln und an die beschriebene Auswerteinheit 69 weiterleiten, so daß dann je nach Betriebszustand die einzelnen Ventile 34, 36, 37, 51, 52, 30 gleichzeitig oder mit zeitlichem Abstand versetzt zueinander ansteuerbar sind, um auf diese Weise die Zuführeinrichtung 6 und somit auch die bereits beschriebenen Auffangbehälter 27, 31 rechtzeitig mit Lackflüssigkeit zu versorgen.

Die beiden Meßfühler 41, 42 können als Widerstandsmeßfühler ausgebildet sein.

Ferner ist es möglich, im Bereich der Heizung 39 einen Sensor für die Lacktemperatur vorzusehen, so daß hierüber die Heizung 39 entsprechend angesteuert werden kann.

Ist beispielsweise der untere Auffangbehälter 31 nicht entsprechend aufgefüllt, so wird über den unteren Meßfühler 42 eine entsprechende Stellgröße an die Auswerteinheit 69 übermittelt, über die dann das Steuerventil 34, 36 geöffnet werden kann.

Im Ausführungsbeispiel gemäß Figur 3, 4 ist die Zuführeinrichtung 6 zur Aufbringung der Flüssigkeit bzw. des Lacks 4 im Bereich des Lackierkopfs 49 bzw. des Substrats 2 dargestellt. Die Zuführeinrichtung 6 besteht aus einer mit Bezug auf Figur 3 und 4 horizontal verlaufenden Tragvorrichtung 8, die an einer in der Zeichnung nicht dargestellten Halterung bzw. an einem Gehäuse angeordnet ist. Die Halterung 8 weist ein in etwa kastenförmiges, aus Seitenteilen 76' bis 76'''' gebildetes Gehäuse auf, in dem eine Antriebsvorrichtung 3 mit einem Schrittmotor 9 zum Antrieb eines Getriebes bzw. Zahnstangen- oder Schneckenschrauben-Getriebes 15 vorgesehen ist. Der Schrittmotor 9 treibt also über das Getriebe 9 die Zuführeinrichtung 6 an, so daß diese parallel zur Oberfläche des Substrats 2 verstellt werden kann.

Die Tragvorrichtung 8 besteht aus einem sich mit Bezug auf den Tragarm 8 vertikal erstreckenden Teil mit einer am oberen Ende vorgesehenen Halterung 68 zur Aufnahme einer Versorgungsleitung 17, an deren oberen Ende die Düse 5 angeschlossen ist, so daß über diese der Lack 4 auf das Substrat 2 abgegeben werden kann. Die Versorgungsleitung 17 ist über die Leitungen 47, die Heizung 39 sowie die Leitung 46 und die Pumpe 29 an den unteren Sammelbehälter 31 angeschlossen.

Wie insbesondere aus Figur 3 hervorgeht, ist die Zuführeinrichtung 6 in der Tragvorrichtung 8 zwischen einer extrem rechten und einer extrem linken Stellung in horizontaler und vertikaler Höhe verstellbar.

Damit ein horizontales und vertikales Verstellen der Zuführeinrichtung 6 möglich ist, weist die Tragvorrichtung 8 eine erste Kulissenführung 7 auf, die aus einem horizontal verlaufenden Teil 11, einem sich daran anschließenden, geneigt verlaufenden Teil 12 sowie einem sich wiederum daran anschließenden, ebenfalls horizontal verlaufenden Teil 13 gebildet ist, die zur Aufnahme von Gleitelementen bzw. Rollenlagern 10 dienen. Befindet sich die Zuführeinrichtung 6 in der Stellung gemäß Figur 3, so hat sie ihre untere Position bzw. die Position eingenommen, in der die Düse 5 Lack an das Substrat 2 abgeben kann. Der Lackauftrag über die Düse 5 beginnt am Innendurchmesser des Substrats 2, so daß durch die Rotationsbewegung des Substratträgers 14 das mit der Düse 5 auf das Substrat 2 abgegebene Medium bzw. der Lack gleichmäßig nach außen verteilt und der Rest über den Lackierkopf 49 aufgefangen wird. Der horizontal verlaufende Teil 11 der Kulissenführung 7 ist dabei in vorteilhafter Weise so groß wie der entsprechende Lackierradius verschiedener Substratformen, so daß die Möglichkeit besteht, bei jedem beliebigen Durchmesser das Substrat mit Lack zu beschichten, ohne daß beim Verstellen der Zuführeinrichtung 6 der Abstand zwischen dem unteren Ende der Düse 5 und der Oberfläche des Substrats 2 verändert wird. Auf diese Weise kann die Fallhöhe des aus der Düse 5 austretenden Lacks konstant gehalten und sichergestellt werden, daß ein gleichmäßiger Lackauftrag erfolgt.

Der untere, horizontal verlaufende Teil 13 der Kulissenführung 7 gewährleistet also auch, daß über den Schrittmotor 9 eine exakte Positionierung der Düse 5 an jeder beliebigen Stelle oberhalb des Substrats 2 möglich ist, ganz gleich an welcher Stelle der Lackauftrag auf die Oberfläche des Substrats 2 erfolgen soll. Wird die Zuführeinrichtung 6 über das geneigt verlaufende Teil 12 in das horizontal verlaufende Teil 11 bewegt, so führt die Zuführeinrichtung 6 zuerst eine horizontale und dann eine horizont-vertikale, anschließend wieder eine horizontale Bewegung aus. Bei diesem Stellvorgang wird mittels eines Sensors die Referenzstellung erfaßt.

In den beiden an die Zuführeinrichtung 6 angeschlossenen Gleitelementen bzw. Rollenlagern 10, die in der ersten Kulissenführung 7 aufgenommen sind, können zwei weitere mit Abstand zu den ersten Rollenlagern angeordnete Rollenlager 10' vorgesehen werden, die in einer weiteren Kulissenführung 7' aufgenommen sind. Die Kulissenführung 7' verläuft parallel zum Teil 11, 13 der Kulissenführung 7 und stellt sicher, daß ein Kippen der Zuführeinrichtung 6 vermieden wird. Wird also der Schrittmotor 9 angetrieben, so wird über eine Spindel und eine zugehörige Kulisse bzw. Mutter 70 die Zuführeinrichtung 6 entweder nach rechts oder nach links bewegt.

Damit eine Beschädigung der Versorgungsleitung 17 ausgeschlossen wird, ist diese durch entsprechende in der Zuführeinrichtung 6 vorgesehene Bohrungen bzw. einen Freiraum geführt.

Da alle wesentlichen Bauteile, insbesondere die Antriebsvorrichtung 3, ein großer Teil der Zuführeinrichtung 6 sowie die Versorgungsleitung 17, in der Tragvorrichtung 8 untergebracht sind, werden diese nicht nur vor Beschädigung, sondern auch vor Verschmutzungen mit Lack geschützt.

Wie aus Figur 1 insbesondere hervorgeht, kann, wie bereits beschrieben, das vom Substratträger 14 abgegebene, flüssige Medium bzw. der Lack 4 über Leitelemente 19, 20 zumindest an den ersten Auffangbehälter 27 abgegeben werden, der mit mindestens einem Filter 28 verbunden ist, von dem die Flüssigkeit mittel- oder unmittelbar über eine Pumpe 29 an den ersten Auffangbehälter 27 geleitet wird, wobei zwischen der ersten Abflußleitung 33 des ersten Auffangbehälters 27 und der Pumpe 29 ein Unterdruck über eine als Venturi-Düse ausgebildete Pumpe 30 einstellbar ist.

Die Vakuumpumpe 30 ist an eine Rücklaufeinrichtung 32 angeschlossen, die aus den Leitungen 33, 59 und 39 und dem Filter 28 besteht. Die Vakuumpumpe 30 steht über eine Leitung 44 mit dem zweiten Auffangbehälter 31 in Verbindung. Die vom Substratträger 14 abgeschleuderte Flüssigkeit bzw. das flüssige Lackmedium wird über den ersten Auffangbehälter 27 an den ersten Filter 28 geleitet, wobei in der Anlage die Rücklaufeinrichtung 32 an die Unterdruckeinrichtung bzw. das Venturi-Rohr 44 angeschlossen ist, über das der Unterdruck erzeugt wird. Dadurch läßt sich auch Flüssigkeitsmedium bzw. Lack mit hoher Viskosität durch die Filteranlage bewegen und für die Flüssigkeit die gewünschte Reinheit bei störungsfreiem Förderbetrieb erreichen. Durch den Vakuumbetrieb können auch Filter 28 mit sehr engmaschigen Filterelementen 28 eingesetzt werden, ohne daß dadurch die Durchlaufzeit des Lacks in der gesamten Vorrichtung nachteilig beeinträchtigt wird. Durch das vorteilhafte Einsetzen des Unterdruckbetriebs können derartige Filter 28 auch wesentlich länger im Einsatz bleiben, da neben der Pumpe 29 in Verbindung mit dem Unterdruck eine hohe Durchlaufgeschwindigkeit der Lackflüssigkeit sichergestellt wird.

Im Ausführungsbeispiel ist das Venturi-Rohr oder die Vakuumpumpe 30 an den Auffangbehälter 31 angeschlossen. Die Vakuumpumpe 30 kann auch an jeder anderen geeigneten Stelle zwischen dem ersten Auffangbehälter 27 und der Pumpe oder Dosierpumpe 29 angeschlossen werden. Die Dosierpumpe 29 ist über ein Stellventil 37 der Rückführeinrichtung 32 zuschaltbar.

### Bezugszeichenliste

- 1: Vorrichtung zur Oberflächenbeschichtung bzw. zum Lackieren von Substraten
- 2: Substrat, CD
- 3: Antriebsvorrichtung
- 4: Lackflüssigkeit
- 4': Lackflüssigkeit
- 5: Düse
- 6: Zuführeinrichtung
- 7: Kulissenführung, Führungseinrichtung
- 8: Tragvorrichtung
- 9: Schrittmotor
- 10: Gleitelemente bzw. Rollager
- 10': Gleitelemente bzw. Rollager
- 11: horizontaler Teil
- 12: geneigter Teil
- 13: horizontaler Teil
- 14: Substratträger, Teller
- 15: Getriebe bzw. Zahnstangen- oder Schneckengetriebe
- 17: Versorgungsleitung
- 18: Leitvorrichtung
- 19: Leitelement
- 20: Leitelement
- 22: Leitvorrichtung
- 23: Ablauföffnung
- 24: Absaugöffnung
- 25: koaxial angeordneter Teil
- 26: zentrisch angeordnete Bohrung
- 27: erster Auffangbehälter
- 28: Filter
- 29: Pumpe, Dosierpumpe, Membranpumpe
- 30: Vakuumpumpe, Venturi-Düse
- 31: zweiter Behälter, Auffangbehälter
- 32: Rücklaufeinrichtung
- 33: Flüssigkeitsleitung
- 34: erstes Ventil
- 35: Tank
- 36: zweites Ventil
- 37: Absperrventil
- 38: Rückschlagventil
- 39: Leitung
- 40: Füllstandsanzeige
- 41: Meßfühler
- 42: Meßfühler
- 44: Leitung
- 45: Leitung
- 47: Leitung
- 49: Lackierkopf
- 51: Ventil
- 52: Ventil
- 53: Boden
- 54: Welle
- 56: Steg mit Öffnungen
- 57: Ringkanal
- 58: Venturi-Düse
- 59: Flüssigkeitsleitung
- 60: Antriebsmotor
- 61: Auslaßöffnung
- 62: zweite Einlaßöffnung
- 63: Schrittmotor
- 65: Auswerteinheit
- 66: Seitenteil
- 67: Sensor
- 68: Halterung
- 69: Auswerteinheit
- 70: Kulisse
- 71: Leitung der Auswerteinheit
- 73: Stellventil
- 74: Einlaßöffnung
- 75: Rohr
- 76' - 76'''': Seitenteil
- R: Mittelachse

## Patentansprüche

1. Vorrichtung zur Oberflächenbeschichtung bzw. zum Lackieren von Substraten bzw. scheibenförmigen Substraten (2) wie einem scheibenförmigen Informationsträger, der auf einen Substratträger (14) aufbringbar und über eine Antriebsvorrichtung (3) antreibbar bzw. in eine Rotationsbewegung versetzbar ist, wobei das aufzutragende Mittel bzw. die Lackflüssigkeit (5) über eine gegenüber dem Substrat (2) verstellbare und/oder antreibbare Zuführeinrichtung (6) auf das Substrat (2) aufgegeben wird, **dadurch gekennzeichnet**, daß das Substrat (2) bzw. der Substratträger (14) eine Führungseinrichtung bzw. eine Kulissenführung (7) aufweist, die einen ersten und zweiten Führungsteil (11, 13) enthält, die mit Bezug auf die Standfläche der Vorrichtung einen unterschiedlichen Abstand aufweisen.

2. Vorrichtung nach Anspruch 1, **dadurch gekennzeichnet**, daß die Zuführungseinrichtung (6) mit der Antriebsvorrichtung (3) verbunden und von einer Tragvorrichtung (8) aufgenommen ist.

3. Vorrichtung nach Anspruch 1 oder 2, **dadurch gekennzeichnet**, daß die Zuführungseinrichtung (6) mittels der Führungseinrichtung (7) in horizontaler und/oder in vertikaler Richtung verstellbar ist.

4. Vorrichtung nach Anspruch 1, **dadurch gekennzeichnet,** daß die Antriebsvorrichtung (3) mit einem Schrittmotor bzw. elektrischen oder elektrohydraulischen Schrittmotor (9) wirkungsmäßig verbunden ist.

5. Vorrichtung nach einem oder mehreren der vorhergehenden Ansprüche, **dadurch gekennzeichnet,** daß die Antriebsvorrichtung (3) einen Schrittmotor (9) aufweist, der über ein Getriebe bzw. Zahnstangen- oder Schneckengetriebe (15) mit der Führungseinrichtung (7) wirkungsmäßig verbunden ist.

6. Vorrichtung nach Anspruch 1, **dadurch gekennzeichnet,** daß die Antriebsvorrichtung (3) in einem Tragarm (8) angeordnet oder diesem zugeordnet ist, in dem die Kulissenführung (7) vorgesehen ist, die aus einem ersten horizontal (11), einem sich daran anschließenden, geneigt (12) verlaufenden und einem sich wiederum daran anschließenden, horizontal verlaufenden Teil (13) gebildet ist und in der Gleitelemente (10) bzw. Rollager vorgesehen sind bzw. sich bewegen, wobei neben der ersten Kulissenführung (7) eine zweite Kulissenführung (7') vorgesehen sein kann, die parallel zum ersten und/oder zweiten Teil (11, 13) verläuft.

7. Vorrichtung nach einem oder mehreren der vorhergehenden Ansprüche, **dadurch gekennzeichnet,** daß in der Zuführeinrichtung (6) zur Förderung der Flüssigkeit bzw. des Lacks (4) eine Versorgungsleitung (17) aufgenommen ist, die gemeinsam mit der Zuführeinrichtung (6) verstellbar ist.

8. Vorrichtung nach einem oder mehreren der vorhergehenden Ansprüche, **dadurch gekennzeichnet,** daß der Schrittmotor (9) mit einem Sensor (67) in einer Endlagestellung zusammenwirkt, von der aus die Stellung der Zuführeinrichtung (6) und der Schrittmotor (9) vorwählbar und in jede beliebige Stellung oberhalb des Substrats (2) verstellbar ist.

9. Vorrichtung nach einem oder mehreren der vorhergehenden Ansprüche, **dadurch gekennzeichnet,** daß das über die Zuführeinrichtung (6) mit Lack (4) versorgbare Substrat (2) auf einem Substrathalter (14) auflegbar ist, der mit einer den Substrathalter (14) umgebenden, kreis- bzw. zylinderförmigen Leitvorrichtung (18) ausgestattet ist.

10. Vorrichtung nach einem oder mehreren der vorhergehenden Ansprüche, **dadurch gekennzeichnet,** daß die Leitvorrichtung (18) aus zwei pyramidenstumpfförmigen, gegeneinander anliegenden Leitflächen bzw. Leitelementen (19, 20) besteht, über die der Lack einem ersten Behälter (27) zugeführt wird.

11. Vorrichtung nach einem oder mehreren der vorhergehenden Ansprüche, **dadurch gekennzeichnet,** daß die erste Leitvorrichtung (18) von einer zweiten kreis- bzw. zylinderförmigen Leitvorrichtung (22) umgeben ist.

12. Vorrichtung nach einem oder mehreren der vorhergehenden Ansprüche, **dadurch gekennzeichnet,** daß die erste und zweite kreis- bzw. zylinderförmige Leitvorrichtung (18, 22) mindestens je eine Öffnung (23, 24) aufweist, wobei die erste Öffnung eine Ablauföffnung für Lack und die zweite eine Absaugöffnung für den Lacknebel ist.

13. Vorrichtung nach einem oder mehreren der vorhergehenden Ansprüche, **dadurch gekennzeichnet,** daß ein koaxial angeordneter Teil (25) der zweiten Leitvorrichtung (22) mit einer zentrisch angeordneten Bohrung (26) ausgestattet ist.

14. Vorrichtung nach einem oder mehreren der vorhergehenden Ansprüche, **dadurch gekennzeichnet,** daß der Substratträger (14) von beiden Leitvorrichtungen (18, 22) koaxial umgeben ist.

15. Vorrichtung nach einem oder mehreren der vorhergehenden Ansprüche, **dadurch gekennzeichnet,** daß der Substratträger (14) von mindestens einer Leitvorrichtung bzw. von der inneren Leitvorrichtung (19) getragen wird.

16. Vorrichtung nach Anspruch 1, **dadurch gekennzeichnet,** daß das Substrat (2) bzw. der Substratträger (14) mittels einer Führungseinrichtung bzw. in einer Kulissenführung (7) derart verstellbar ist, daß die Zuführeinrichtung (6) zur Aufbringung der Flüssigkeit bzw. des Lacks im Bereich des Substrats (2) in etwa parallel zur Oberfläche des Substrats (2) geführt und an jeder beliebigen Stelle oberhalb des Substrats (2) im gleichmäßigen Höhenabstand angehalten werden kann.
